# EUROPEAN PATENT APPLICATION

(11) **EP 3 961 739 A1**
(43) Date of publication of application: **02.03.2022**
(21) Application number: 19926422.7
(22) Date of filing: 26.04.2019
(51) Int. Cl.: H01L 51/50, G09F 9/30, H01L 27/32

(54) **ORGANIC ELECTRONIC MATERIAL AND METHOD FOR PRODUCING CHARGE-TRANSPORTING POLYMER**

(71) Applicant: Showa Denko Materials Co., Ltd., Tokyo 100-6606 (JP)
(72) Inventor: KAMO, Kazuyuki, Tokyo 100-6606 (JP); FUKUSHIMA, Iori, Tokyo 100-6606 (JP); ISHITSUKA, Kenichi, Tokyo 100-6606 (JP); MIYA, Takanori, Tokyo 100-6606 (JP)
(74) Representative: Becker, Eberhard
(86) International application number: PCT/JP2019/018129
(87) International publication number: WO 2020/217521

(57) **Abstract**

An embodiment of the present invention relates to an organic electronic material which includes a charge-transporting polymer comprising a structural unit represented by formula (1), at least one structural unit selected from the group consisting of structural units represented by formula (2-1) and structural units represented by formula (2-2), a structural unit represented by formula (3), and at least one structural unit selected from the group consisting of structural units represented by formula (4-1) and structural units represented by formula (4-2).

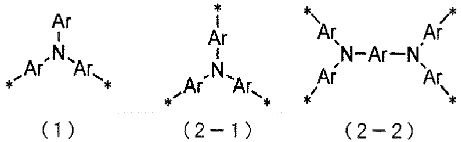

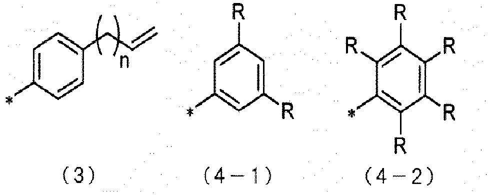

## Description

### BACKGROUND

### Technical Field

Embodiments of the present invention relate to an organic electronics material, a method for preparing a charge-transporting polymer, a liquid composition, an organic layer, an organic electronics element, an organic electroluminescence element (an organic EL element), a display element, a lighting device, and a display device.

### Related Art

Organic electronics elements are elements that perform electrical operations using organic substances, and are expected to exhibit features such as energy saving, low cost, and flexibility. Examples of the organic electronics elements include organic EL elements, organic photoelectric conversion elements, organic transistors and the like.

Further improvements are desired in various element characteristics of the organic EL elements. As an approach to improving the performance of the organic EL elements, attempts have been made to make the organic layers multi-layered and separate the functions in each layer. When the number of layers is increased according to a wet process, the solvent resistance of a lower layer to the solvent of the coating solution used for forming an upper layer is required.

In order to make the organic layer multi-layered, for example, a method of utilizing a compound having at least one polymerizable group has been studied (see Patent literature 1 for example).

### [Literature of related art]

### [Patent literature]

Patent literature 1: Japanese Patent Laid-Open No. 2006-279007

### SUMMARY

### [Problems to be Solved]

An embodiment of the present invention provides an organic electronics material which can obtain a liquid composition having excellent storage stability and can be used for forming a multi-layered organic layer. Another embodiment of the present invention provides a method for preparing a charge-transporting polymer suitable for a charge-transporting polymer used in the organic electronics material. Another embodiment of the present invention provides a liquid composition which has excellent storage stability and can be used for forming a multi-layered organic layer. Another embodiment of the present invention provides an organic layer that can be efficiently formed and can be used for manufacturing an organic electronics element. Still another embodiment of the present invention provides an organic electronics element, an organic EL element, a display element, a lighting device, and a display device including the organic layer.

### [Means to Solve problems]

Examples of embodiments are given below. The present invention is not limited to the following embodiments.

One embodiment relates to an organic electronics material containing a charge-transporting polymer, wherein the charge-transporting polymer comprises a structural unit represented by a formula (1) below, at least one structural unit selected from a group consisting of a structural unit represented by a formula (2-1) below and a structural unit represented by a formula (2-2) below, a structural unit represented by a formula (3) below, and at least one structural unit selected from a group consisting of a structural unit represented by a formula (4-1) below and a structural unit represented by a formula (4-2) below. 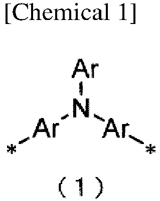 (In the formula, Ar independently represents a substituted or unsubstituted aromatic hydrocarbon group, and at least one Ar is an aromatic hydrocarbon group having a substituent comprising at least one selected from a group consisting of a fluoro group and a fluoroalkyl group.) 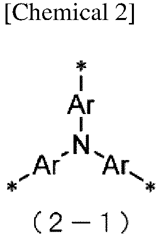 (In the formula, Ar independently represents a substituted or unsubstituted aromatic hydrocarbon group.) 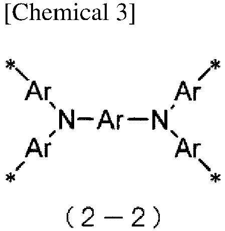 (In the formula, Ar independently represents a substituted or unsubstituted aromatic hydrocarbon group.) 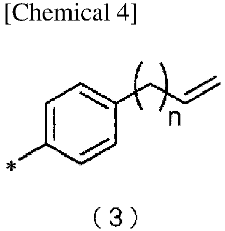 (In the formula, n represents an integer of 1 to 20.) 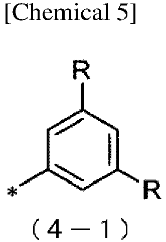 (In the formula, R independently represents a fluoro group and a fluoroalkyl group.) 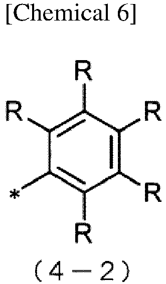 (In the formula, R independently represents a hydrogen atom or a linear alkyl group, and at least one R is a linear alkyl group.)

Another embodiment relates to a method for preparing a charge-transporting polymer which prepares a charge-transporting polymer used in the organic electronics material. The method includes making a monomer mixture react in a solvent containing an aromatic ether, wherein the monomer mixture contains a bifunctional monomer having the structural unit represented by the formula (1), at least one trifunctional or tetrafunctional monomer selected from a group consisting of a trifunctional monomer having the structural unit represented by the formula (2-1) and a tetrafunctional monomer having the structural unit represented by the formula (2-2), a monofunctional monomer having the structural unit represented by the formula (3), and at least one monofunctional monomer selected from a group consisting of a monofunctional monomer having the structural unit represented by the formula (4-1) and a monofunctional monomer having the structural unit represented by the formula (4-2).

Another embodiment relates to a liquid composition containing the organic electronics material and a solvent.

Another embodiment relates to an organic layer formed using the organic electronics material or the liquid composition.

Another embodiment relates to an organic electronics element having at least one of the organic layer.

Another embodiment relates to an organic electroluminescence device having at least one of the organic layer.

Another embodiment relates to a display element including the organic electroluminescence element, a lighting device including the organic electroluminescence element, and a display device including the lighting device and a liquid crystal element as a display part.

### [Effect]

According to an embodiment of the present invention, it is possible to provide an organic electronics material which can obtain a liquid composition having excellent storage stability and can be used for forming a multi-layered organic layer. According to another embodiment of the present invention, it is possible to provide a method for preparing a charge-transporting polymer suitable for a charge-transporting polymer used in the organic electronics material. According to another embodiment of the present invention, it is possible to provide a liquid composition which has excellent storage stability and can be used for forming a multi-layered organic layer. According to another embodiment of the present invention, it is possible to provide an organic layer that can be efficiently formed and can be used for manufacturing an organic electronics element. According to still another embodiment of the present invention, it is possible to provide an organic electronics element, an organic EL element, a display element, a lighting device, and a display device including the organic layer.

### BRIEF DESCRIPTION OF THE DRAWINGS

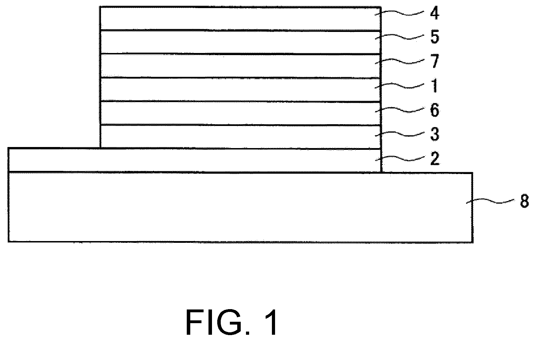

FIG. 1 is a schematic cross-sectional view showing an example of an organic EL element according to an embodiment.

### DESCRIPTION OF THE EMBODIMENTS

Embodiments of the present invention are described. The present invention is not limited to the following embodiments.

### <Organic electronics materials>

One embodiment of the present invention relates to an organic electronics material containing at least a charge-transporting polymer that comprises a structural unit represented by formula (1), at least one structural unit selected from a group consisting of a structural unit represented by formula (2-1) and a structural unit represented by formula (2-2), a structural unit represented by formula (3), and at least one structural unit selected from a group consisting of a structural unit represented by formula (4-1) and a structural unit represented by formula (4-2). The organic electronics material may further contain any component such as a dopant, a polymerization initiator and the like.

In the present disclosure, the "structural unit represented by formula (X)" may be referred to as the "structural unit (X)". In addition, "at least one structural unit selected from a group consisting of a structural unit represented by formula (Y-1) and a structural unit represented by formula (Y-2)" may be referred to as "structural unit (Y)".

### [Charge-transporting polymer]

The charge-transporting polymer comprises at least the structural unit (1), the structural unit (2), the structural unit (3), and the structural unit (4). The charge-transporting polymer may further comprise any structural unit different from the structural units (1) to (4).

### (Structural unit (1))

The charge-transporting polymer comprises a structural unit (1). The structural unit (1) is a divalent structural unit having two binding sites with other structural units. By comprising the structural unit (1), an organic layer having an appropriate energy level can be formed. The charge-transporting polymer may comprise only one type of the structural unit (1) or may comprise two or more types.

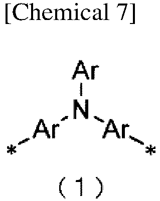

In the formula, Ar independently represents a substituted or unsubstituted aromatic hydrocarbon group, and at least one Ar is an aromatic hydrocarbon group having a substituent comprising at least one group selected from a group consisting of a fluoro group and a fluoroalkyl group.

In the present disclosure, "^{∗}" in the structural formula represents a binding site with another structural unit or structure.

An aromatic hydrocarbon group is an atomic group obtained by removing one or two hydrogen atoms from an aromatic hydrocarbon. The number of carbon atoms of the aromatic hydrocarbon group is preferably 6 to 30, more preferably 6 to 14, and further preferably 6 to 10. Examples of the aromatic hydrocarbon include benzene, naphthalene, anthracene, tetracene, fluorene, phenanthrene, 9,10-dihydrophenanthrene, triphenylene, pyrene, chrycene, perylene, triphenylene, pentacene, benzopyrene and the like.

Ar is preferably a substituted or unsubstituted benzene group, a substituted or unsubstituted naphthalene group, or a substituted or unsubstituted anthracene group, respectively, and is more preferably a substituted or unsubstituted benzene group, or a substituted or unsubstituted naphthalene group.

The aromatic hydrocarbon group may have a substituent. The substituent may be, for example, a substituent selected from a group consisting of -R¹, -OR², -SR³, -OCOR⁴, -COOR⁵, -SiR⁶R⁷R⁸ and a halogen atom (hereinafter, may be referred to as "substituent Ra").

R¹ is selected from a group consisting of an alkyl group, an aryl group and a heteroaryl group. R² to R⁸ is independently selected from a group consisting of a hydrogen atom, an alkyl group, an aryl group and a heteroaryl group. The halogen atom may be a fluorine atom, a chlorine atom, a bromine atom and an iodine atom.

The alkyl group may be linear, branched or cyclic. The alkyl group preferably has 1 to 22 carbon atoms. The aryl group preferably has 6 to 30 carbon atoms. The heteroaryl group preferably has 2 to 30 carbon atoms. The alkyl group, the aryl group and the heteroaryl group may be substituted or unsubstituted.

Examples of the substituent when the alkyl group, the aryl group and the heteroaryl group have a substituent include the substituent Ra and is preferably -R¹. Examples of the alkyl group having a substituent include an arylalkyl group, a heteroarylalkyl group, a fluoroalkyl group and the like. Examples of the aryl group having a substituent include an alkylaryl group, a fluoroaryl group and the like. Examples of the heteroaryl group having a substituent include an alkyl heteroaryl group and the like.

The alkyl group may be, for example, methyl group, ethyl group, n-propyl group, n-butyl group, n-pentyl group, n-hexyl group, n-heptyl group, n-octyl group, n-nonyl group, n-decyl group, n-undecyl group, n-dodecyl group, isopropyl group, isobutyl group, sec-butyl group, tert-butyl group, 2-ethylhexyl group, 3,7-dimethyloctyl group, cyclohexyl group, cycloheptyl group, cyclooctyl group and the like.

In the present disclosure, the aryl group is an atomic group obtained by removing one hydrogen atom from an aromatic hydrocarbon. The heteroaryl group is an atomic group obtained by removing one hydrogen atom from an aromatic heterocyclic compound. The aromatic hydrocarbon here may be a monocyclic ring, a condensed ring, or a polycyclic ring in which two or more rings selected from a monocyclic ring and a condensed ring are directly bonded via a direct bond. The aromatic heterocyclic compound here may be a monocyclic ring, a condensed ring, or a polycyclic ring in which two or more rings selected from a monocyclic ring and a condensed ring are directly bonded via a direct bond.

Examples of the aromatic hydrocarbon in the aryl group include benzene, naphthalene, anthracene, tetracene, fluorene, phenanthrene, 9,10-dihydrophenanthrene, triphenylene, pyrene, chrysen, perylene, triphenylene, pentacene, benzopyrene, biphenyl, terphenyl, triphenylbenzene and the like. Examples of the aromatic heterocyclic compounds in the heteroaryl group include pyridine, pyrazine, quinoline, isoquinoline, aclysine, phenanthroline, carbazole, furan, benzofuran, dibenzofuran, pyrrole, thiophene, benzothiophene, dibenzothiophene, oxazole, oxadiazol, thiadiazole, triazole, benzoxazole, benzoxadiazole, benzothiadiazole, benzotriazole, benzothiophene, bithiophene and the like.

In formula (1), at least one Ar is an aromatic hydrocarbon group having a substituent containing at least one group selected from a group consisting of a fluoro group and a fluoroalkyl group. The fluoroalkyl group preferably has 1 to 4 carbon atoms, more preferably 1 or 2 carbon atoms. The fluoroalkyl group is preferably a perfluoroalkyl group.

For example, from the viewpoint of achieving both a deep HOMO level and a large energy gap between HOMO and LUMO, it is preferable that at least one Ar is an aromatic hydrocarbon group having a fluoro group and all of Ar are aromatic hydrocarbon groups having no fluoroalkyl group in the structural unit (1).

On the other hand, for example, from the viewpoint of obtaining a deeper HOMO level, it is preferable that at least one Ar is an aromatic hydrocarbon group having a fluoroalkyl group in the structural unit (1).

The number of the fluoro group or the fluoroalkyl group contained in the structural unit (1) is preferably 1 to 8, more preferably 1 to 6, further preferably 1 to 4, and particularly preferably 1 to 3. In the case of the above number, the effect of deepening the HOMO level tends to be easily obtained. In addition, in the case of the above number, it tends to be easy to prevent the charge-transporting polymer from becoming too low in solubility.

The structural unit (1) preferably comprises, for example, the following structural unit (1a).

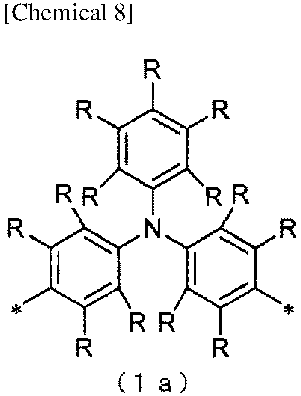

In the formula, R independently represents a hydrogen atom or a substituent, and at least one R is a fluoro group or a fluoroalkyl group.

The fluoroalkyl group preferably has 1 to 4 carbon atoms, more preferably 1 or 2 carbon atoms. The fluoroalkyl group is preferably a perfluoroalkyl group. In the formula, the number of R which is a fluoro group or a fluoroalkyl group is preferably 1 to 8, more preferably 1 to 6, further preferably 1 to 4, and particularly preferably 1 to 3.

The R which is not a fluoro or fluoroalkyl group is a hydrogen atom or a substituent. Examples of the substituent include the substituent Ra (however, the fluoro group and the fluoroalkyl group are excluded here). From the viewpoint of suppressing the influence of the substituent, all Rs that are not fluoro groups or fluoroalkyl groups may be hydrogen atoms.

The structural unit (1) preferably comprises, for example, at least one structural unit selected from a group consisting of the following structural units (1b) to (1e).

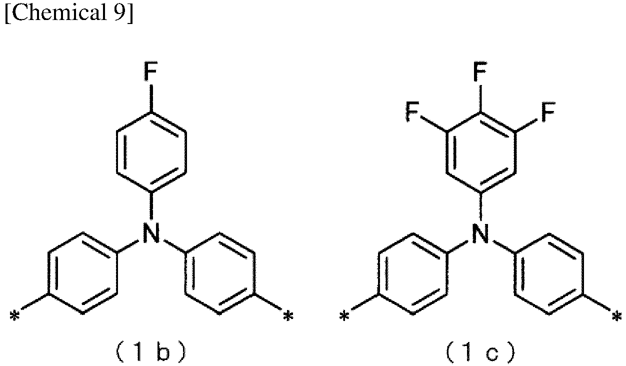

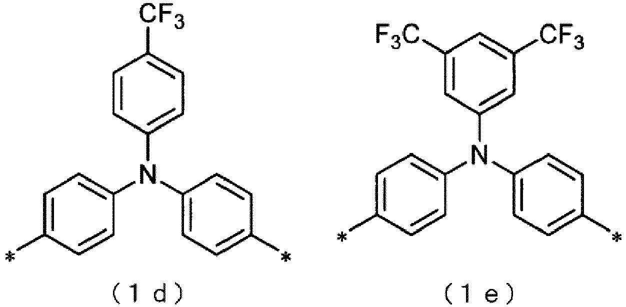

When the charge-transporting polymer comprises the structural unit (1b) and/or the structural unit (1c), deep HOMO levels and a large energy gap between HOMO and LUMO tend to be easily obtained. When the charge-transporting polymer comprises a structural unit (1d) and/or a structural unit (1e), a deeper HOMO level tends to be easily obtained. When the charge-transporting polymer comprises the structural unit (1e), good solubility of the charge-transporting polymer tends to be easily obtained.

### (Structural unit (2))

The charge-transporting polymer comprises at least one structural unit (2) selected from a group consisting of a structural unit (2-1) and a structural unit (2-2). The structural unit (2-1) is a trivalent structural unit having three binding sites with other structural units. The structural unit (2-2) is a tetravalent structural unit having four binding sites with other structural units. The structural unit (2) is a trivalent or tetravalent structural unit having three or four binding sites with other structural units. By comprising the structural unit (2), the charge-transporting polymer becomes a branched polymer and becomes a polymer having three or more ends in one molecule. The branched polymer can easily increase the molecular weight thereof and tends to exhibit good solubility. The charge-transporting polymer may comprise only one type of the structural unit (2) or may comprise two or more types.

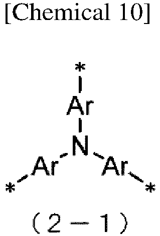

In the formula, Ar independently represents a substituted or unsubstituted aromatic hydrocarbon group.

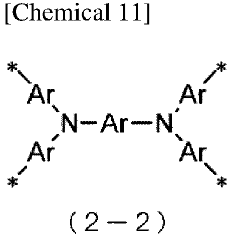

In the formula, Ar independently represents a substituted or unsubstituted aromatic hydrocarbon group.

As for the substituted or unsubstituted aromatic hydrocarbon group, the description regarding the substituted or unsubstituted aromatic hydrocarbon group in the structural unit (1) can be applied. Ar is preferably an unsubstituted aromatic hydrocarbon group.

In the structural unit (2-1), Ar is preferably a substituted or unsubstituted benzene group, a substituted or unsubstituted naphthalene group, or a substituted or unsubstituted anthracene group, respectively, more preferably a substituted or unsubstituted benzene group or a substituted or unsubstituted naphthalene group, and further preferably a substituted or unsubstituted benzene group.

In the structural unit (2-2), Ar is preferably a substituted or unsubstituted benzene group, a substituted or unsubstituted naphthalene group, or a substituted or unsubstituted anthracene group, respectively, more preferably a substituted or unsubstituted benzene group or a substituted or unsubstituted naphthalene group, and further preferably a substituted or unsubstituted benzene group.

The structural unit (2) preferably comprises, for example, at least one structural unit selected from a group consisting of the following structural unit (2-1a), the following structural unit (2-1b), and the following structural unit (2-2a).

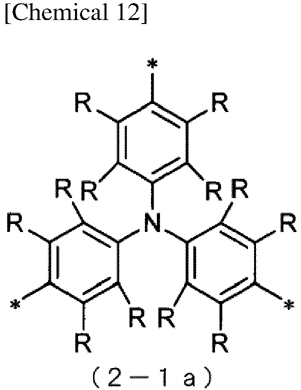

In the formula, R independently represents a hydrogen atom or a substituent. Examples of the substituent include the substituent Ra.

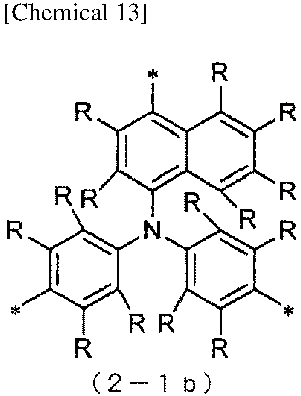

In the formula, R independently represents a hydrogen atom or a substituent. Examples of the substituent include the substituent Ra.

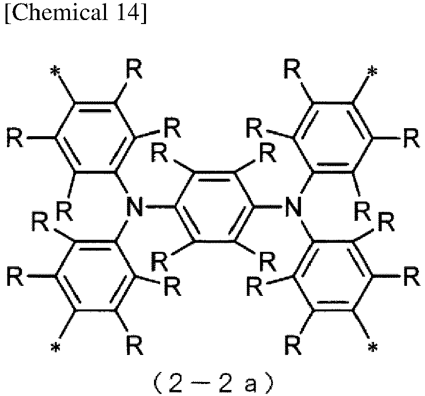

In the formula, R independently represents a hydrogen atom or a substituent. Examples of the substituent include the substituent Ra.

The structural unit (2) preferably comprises, for example, at least one structural unit selected from a group consisting of the following structural units (2-1c), (2-1d), and (2-2b).

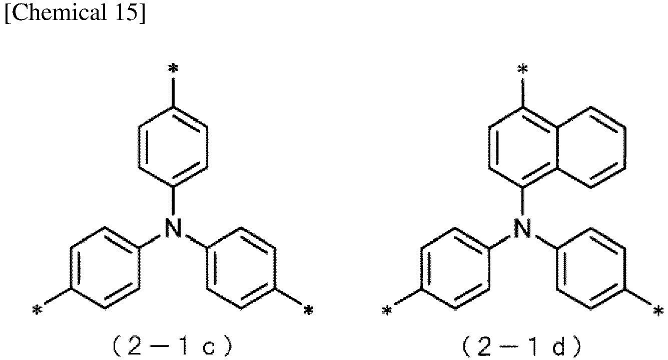

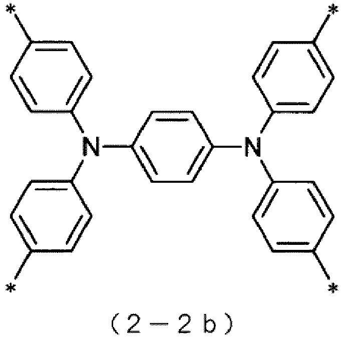

### (Structural unit (3))

The charge-transporting polymer comprises a structural unit (3). The structural unit (3) is a monovalent structural unit having one binding site with another structural unit. The structural unit (3) is contained at the end of the polymer chain of the charge-transporting polymer. By containing the structural unit (3), a liquid composition having excellent storage stability can be obtained. In addition, by containing the structural unit (3), an organic layer having excellent solvent resistance can be obtained, and a multi-layered organic layer can be easily introduced into an organic electronics element. The charge-transporting polymer may comprise only one type of structural unit (3) or two or more types.

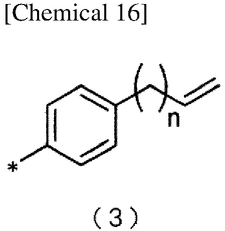

In the formula, n represents an integer of 0 to 20. From the viewpoint of improving the life characteristics, n is preferably 0 to 8, more preferably 0 to 6, further preferably 0 to 3, and particularly preferably 0 or 1. From the viewpoint of improving solubility, n is preferably 4 to 20, more preferably 4 to 16, further preferably 4 to 12, and particularly preferably 4 to 8.

Because the structural unit (3) has excellent reactivity, the curing reaction of the charge-transporting polymer can be efficiently advanced. In addition, when the charge-transporting polymer comprises the structural unit (3) as a structural unit comprising a polymerizable functional group that contributes to the curing reaction, a liquid composition having excellent storage stability can be obtained. The structural unit (3) preferably has a small value of n in that an organic electronics element exhibiting better life characteristics can be obtained. On the other hand, the structural unit (3) preferably has a large value of n in that excellent solubility can be obtained.

The content of the structural unit (3) is preferably 30 to 95 mol% based on the total amount of the monovalent structural unit forming the end portion of the polymer chain. From the viewpoint of improving the solvent resistance of the organic layer, the content of the structural unit (3) is preferably 30 mol% or more, more preferably 40 mol% or more, further preferably 55 mol% or more, and particularly preferably 70 mol% or more. From the viewpoint of improving the solubility of the charge-transporting polymer, the content of the structural unit (3) is preferably 95 mol% or less, more preferably 90 mol% or less, and further preferably 85 mol% or less. In order to obtain high solubility, the content of the structural unit (3) may be 45 mol% or less, or 40 mol% or less.

The structural unit (3) preferably comprises, for example, the following structural unit (3a).

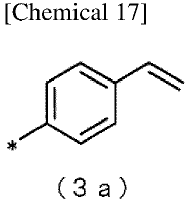

### (Structural unit (4))

The charge-transporting polymer comprises at least one structural unit (4) selected from a group consisting of a structural unit (4-1) and a structural unit (4-2). The structural unit (4-1), the structural unit (4-2), and the structural unit (4) are monovalent structural units having one binding site with other structural units. The structural unit (4) is contained at the end portion of the polymer chain of the charge-transporting polymer. By comprising the structural unit (4), the solubility of the charge-transporting polymer can be improved. The charge-transporting polymer may comprise only one type of the structural unit (4) or two or more types.

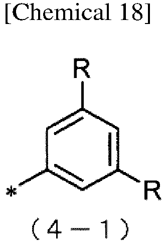

In the formula, R independently represents a fluoro group or a fluoroalkyl group.

The fluoroalkyl group preferably has 1 to 4 carbon atoms, and more preferably 1 or 2 carbon atoms. The fluoroalkyl group is preferably a perfluoroalkyl group.

The two Rs may be the same or different from each other and are preferably the same as each other. Each R is preferably a fluoro group or a fluoroalkyl group, more preferably a fluoroalkyl group, and further preferably a perfluoroalkyl group having 1 to 4 carbon atoms.

When the charge-transporting polymer comprises the structural unit (4-1), a deeper HOMO level tend to be easily obtained.

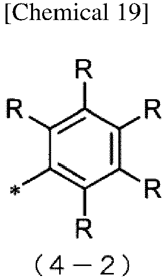

In the formula, R independently represents a hydrogen atom or a linear alkyl group, and at least one R is a linear alkyl group.

The linear alkyl group preferably has 4 to 20 carbon atoms, more preferably 4 to 16 carbon atoms, and further preferably 4 to 12 carbon atoms.

The content of the structural unit (4) is preferably 5 to 70 mol% based on the total amount of the monovalent structural unit forming the end portion of the polymer chain. From the viewpoint of improving the solubility of the charge-transporting polymer, the content of the structural unit (4) is preferably 5 mol% or more, more preferably 10 mol% or more, and further preferably 15 mol% or more. In order to obtain high solubility, the content of the structural unit (4) may be 55 mol% or more, or 60 mol% or more. From the viewpoint of improving the solvent resistance of the organic layer, the content of the structural unit (4) is preferably 70 mol% or less, more preferably 60 mol% or less, further preferably 45 mol% or less, and particularly preferably 30 mol% or less.

The structural unit (4) preferably comprises, for example, at least one structural unit selected from a group consisting of the following structural units (4-1a) and (4-2a).

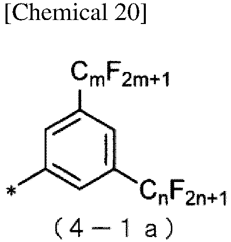

In the formula, n and m each independently represent an integer of 1 to 4. n and m may be the same or different from each other, and are preferably the same.

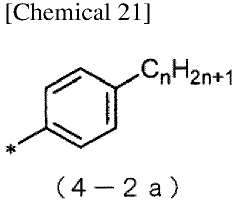

In the formula, n represents an integer of 4 to 20.

In formula (4-2a), n is preferably 4 to 7 from the viewpoint of improving the life characteristics. n is preferably 9 to 20 from the viewpoint of improving solubility. Considering the balance between the improvement of life characteristics and the improvement of solubility, n may be 4 to 16 or 4 to 12.

The structural unit (4) preferably comprises, for example, at least one structural unit selected from a group consisting of the following structural units (4-1b) and (4-2b).

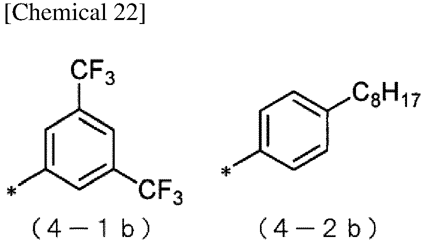

### (Optional structural unit)

The charge-transporting polymer may further contain an optional structural unit different from the structural units (1) to (4) (hereinafter, referred to as "optional structural unit").

The optional structural unit may be, for example, a substituted or unsubstituted aromatic amine structure, a substituted or unsubstituted carbazole structure, a substituted or unsubstituted thiophene structure, a substituted or unsubstituted fluorene structure, a substituted or unsubstituted benzene structure, a substituted or unsubstituted biphenyl structure, a substituted or unsubstituted terphenyl structure, a substituted or unsubstituted naphthalene structure, a substituted or unsubstituted anthracene structure, a substituted or unsubstituted tetracene structure, a substituted or unsubstituted phenanthrene structure, a substituted or unsubstituted dihydrophenanthrene structure, a substituted or unsubstituted pyridine structure, a substituted or unsubstituted pyrazine structure, a substituted or unsubstituted quinoline structure, a substituted or unsubstituted isoquinolin structure, a substituted or unsubstituted quinoxalin structure, a substituted or unsubstituted aclydin structure, a substituted or unsubstituted diazaphenanthrene structure, a substituted or unsubstituted furan structure, a substituted or unsubstituted pyrrole structure, a substituted or unsubstituted oxazole structure, a substituted or unsubstituted oxadiazole structure, a substituted or unsubstituted thiazole structure, a substituted or unsubstituted thiadiazole structure, a substituted or unsubstituted triazole structure, a substituted or unsubstituted benzothiophene structure, a substituted or unsubstituted benzoxazole structure, a substituted or unsubstituted benzoxadiazole structure, a substituted or unsubstituted benzothiazole structure, a substituted or unsubstituted benzothiadiazole structure, a substituted or unsubstituted benzotriazole structure, and a structure comprising one or more of the above structures.

The optional structural unit may be monovalent or higher valent, preferably monovalent to hexavalent, and more preferably monovalent to tetravalent.

The description of the substituent in the structural unit (1) can be applied to the substituent contained in the optional structural unit.

### (Content of each structural unit)

The charge-transporting polymer may comprise a divalent structural unit in addition to the structural unit (1). From the viewpoint of adjusting the energy level, the content of the structural unit (1) is preferably 50 mol% or more, more preferably 75 mol% or more, and further preferably 90 mol% or more based on the total amount of the divalent structural unit. The upper limit of the content of the structural unit (1) is 100 mol%.

From the viewpoint of obtaining sufficient charge-transporting property, the content of the divalent structural unit contained in the charge-transporting polymer is preferably 10 mol% or more, more preferably 15 mol% or more, and further preferably 20 mol% or more based on all the structural units. In addition, considering the monovalent structural unit and the trivalent or higher valent structural unit, the content of the divalent structural unit is preferably 95 mol% or less, more preferably 90 mol% or less, and further preferably 85 mol% or less.

The charge-transporting polymer may comprise a structural unit having a valence of 3 or more in addition to the structural unit (2). From the viewpoint of obtaining good charge-transporting property, the content of the structural unit (2) is preferably 50 mol% or more, more preferably 75 mol% or more, and further preferably 90 mol% based on the total amount of the trivalent or higher valent structural unit. The upper limit of the content of the structural unit (2) is 100 mol%.

From the viewpoint of obtaining an organic layer having excellent solvent resistance, the content of the trivalent or higher valent structural unit contained in the charge-transporting polymer is preferably 1 mol% or more, more preferably 5 mol% or more, and further preferably 10 mol% or more based on all the structural units. In addition, from the viewpoint of suppressing an increase in viscosity and satisfactorily synthesizing the charge-transporting polymer or the viewpoint of obtaining sufficient charge-transporting property, the content of the trivalent or higher valent structural unit is preferably 50 mol% or less, more preferably 40 mol% or less, further preferably 30 mol% or less, and particularly preferably 20 mol% or less.

The charge-transporting polymer may comprise a monovalent structural unit in addition to the structural unit (3) and the structural unit (4). From the viewpoint of obtaining good storage stability of the liquid composition, the total content of the structural unit (3) and the structural unit (4) is preferably 85 mol% or more, more preferably 90 mol% or more, and further preferably 95 mol% or more based on the total amount of the monovalent structural unit. The upper limit of the content of the structural unit (3) is 100 mol%.

From the viewpoint of curability and solubility of the charge-transporting polymer and the viewpoint of improvement of the characteristics of the organic electronics element, the content of the monovalent structural unit contained in the charge-transporting polymer is preferably 5 mol% or more, more preferably 10 mol% or more, and further preferably 15 mol% or more based on all structural units. In addition, from the viewpoint of obtaining sufficient charge-transporting property, the content of the monovalent structural unit is preferably 60 mol% or less, more preferably 55 mol% or less, and further preferably 50 mol% or less.

The charge-transporting polymer may comprise an optional structural unit. From the viewpoint of obtaining a sufficient effect of the structural units (1) to (4), the content of the optional structural unit is preferably 50 mol% or less, more preferably 30 mol% or less, further preferably 20 mol% or less, and particularly preferably 10 mol% or less or 5 mol% or less based on all structural units. The lower limit of the content of the optional structural unit is 0 mol%. That is, the charge-transporting polymer may not comprise an optional structural unit.

As for the ratio (molar ratio) of the contents of the divalent structural unit, the trivalent or higher valent structural unit, and the monovalent structural unit contained in the charge-transporting polymer, considering the balance of effects of each structural unit, the divalent structural unit: the trivalent or higher valent structural unit: the monovalent structural unit is preferably 100: 5 to 70: 50 to 150, more preferably 100: 10 to 60: 60 to 135, and further preferably 100: 15 to 50:80 to 120.

The content of the structural units can be determined using the usage amount of the monomer corresponding to each structural unit used for synthesizing the charge-transporting polymer. In addition, the ratio of the structural units can be calculated as an average value by using the integrated value of the spectrum derived from each structural unit in the ¹H NMR spectrum of the charge-transporting polymer. Because of the simplicity, when the usage amount is clear, it is preferable to adopt the value obtained using the usage amount.

### (Number average molecular weight)

The number average molecular weight of the charge-transporting polymer can be appropriately adjusted in consideration of solubility in a solvent, film-forming property, and the like. From the viewpoint of excellent charge-transporting property, the number average molecular weight is preferably 500 or more, more preferably 1,000 or more, further preferably 2,000 or more, and particularly preferably 5,000 or more. In addition, from the viewpoint of maintaining good solubility in a solvent and facilitating the preparation of a liquid composition, the number average molecular weight is preferably 1,000,000 or less, more preferably 100,000 or less, further preferably 50,000 or less, and particularly preferably 30,000 or less.

### (Weight average molecular weight)

The weight average molecular weight of the charge-transporting polymer can be appropriately adjusted in consideration of solubility in a solvent, film-forming property, and the like. From the viewpoint of excellent charge-transporting property, the weight average molecular weight is preferably 1,000 or more, more preferably 5,000 or more, and further preferably 10,000 or more. In addition, from the viewpoint of maintaining good solubility in a solvent and facilitating the preparation of a liquid composition, the weight average molecular weight is preferably 1,000,000 or less, more preferably 700,000 or less, further preferably 400,000 or less, and particularly preferably 100,000 or less.

The number average molecular weight and the weight average molecular weight can be measured by gel permeation chromatography (GPC) using a standard polystyrene calibration curve. The measurement conditions may be, for example, the conditions described in the examples.

### (Structural example of charge-transporting polymer)

The charge-transporting polymer comprises a divalent structural unit including the structural unit (1), a trivalent or higher valent structural unit including the structural unit (2), and a monovalent structural unit including the structural unit (3) and the structural unit (4). The trivalent or higher valent structural unit forms the branched portion of the charge-transporting polymer, and the monovalent structural unit forms the end portion of the charge-transporting polymer.

According to a preferred embodiment, the charge-transporting polymer comprises a branched structure having at least one structural unit (2) and three or more structural units (1) bound to the one structural unit (2). Preferably, the charge-transporting polymer comprises a multi-branched structure having one structural unit (2) and three or more structural units (1) bound to the one structural unit (2), wherein each of the three or more structural units (1) further has at least one different structural unit (2) bound to the structural unit (1) and two or more different structural units (1) bound to the one different structural unit (2).

Examples of the structure contained in the charge-transporting polymer include the following. In the structure, "L" represents a divalent structural unit, "B" represents a trivalent or higher valent structural unit, and "T" represents a monovalent structural unit. In the following structure, the plurality of Ls may be the same structural unit or different structural units from each other. The same applies to B and T. Note that, the charge-transporting polymer is not limited to those having the following structures.

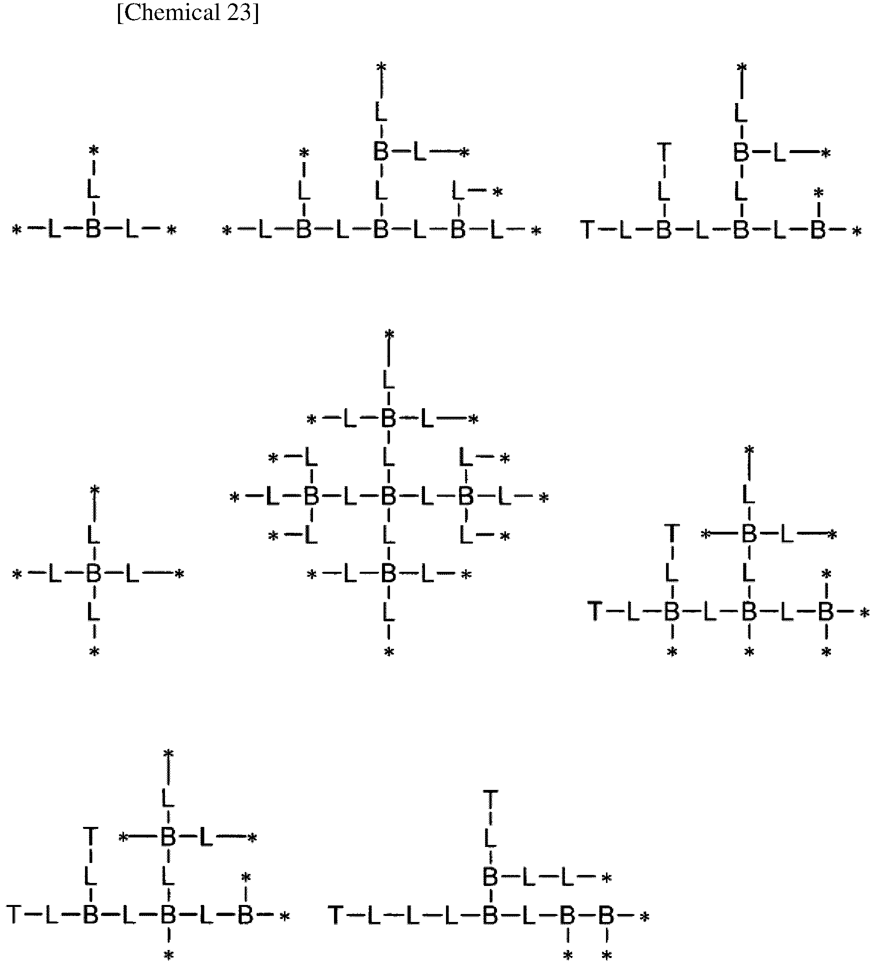

### (Application and the like of charge-transporting polymer)

The charge-transporting polymer has the ability to transport charge. The charge-transporting polymer can adjust the HOMO level to an appropriate level by having the structural unit (1), and has excellent solubility and durability by having the structural unit (2). In addition, because the charge-transporting polymer has the structural unit (3) and the structural unit (4), it is also excellent in curability and solubility. Organic electronics materials containing the above charge-transporting polymer can be preferably used in, for example, a hole transport layer of an organic EL element. Because good solubility can be obtained, the organic electronics material is preferably used by being dissolved in a solvent containing at least one solvent selected from a group consisting of aromatic ethers and aromatic halides.

### < Method for preparing charge-transporting polymer>

One embodiment of the present invention relates to a method for preparing a charge-transporting polymer, which prepares a charge-transporting polymer used in the organic electronics material. The method includes making a monomer mixture react in a solvent containing an aromatic ether, wherein the monomer mixture contains a bifunctional monomer having a structural unit represented by the above formula (1), at least one trifunctional or tetrafunctional functional monomer selected from a group consisting of a trifunctional monomer having a structural unit represented by the above formula (2-1) and a tetrafunctional monomer having a structural unit represented by the above formula (2-2), a monofunctional monomer having a structural unit represented by the above formula (3), and at least one monofunctional monomer selected from a group consisting of a monofunctional monomer having a structural unit represented by the above formula (4-1) and a monofunctional monomer having a structural unit represented by the above formula (4-2). The method for preparing a charge-transporting polymer may further include optional steps such as preparing monomers, mixing the monomer mixture with a solvent, adding a catalyst, cleaning the charge-transporting polymer, and the like.

In the present disclosure, the "monomer having a structural unit represented by formula (X)" may be referred to as "monomer (X)". In addition, "at least one monomer selected from a group consisting of a monomer having a structural unit represented by formula (Y-1) and a monomer having a structural unit represented by formula (Y-2)" may be referred to as "monomer (Y)".

### [Monomer mixture]

The monomer mixture contains at least the monomer (1), the monomer (2), the monomer (3), and the monomer (4). The monomer mixture may further contain an optional monomer different from the monomers (1) to (4).

### (Monomer (1))

The monomer (1) contains one structural unit (1) in the molecule. The monomer (1) can be used to introduce the structural unit (1) into the charge-transporting polymer. The description of the structural unit (1) can be applied to the structural unit (1) contained in the monomer (1). The monomer (1) is a bifunctional monomer having two reactive functional groups.

The monomer (1) is preferably a monomer represented by the following formula (1M) for example.

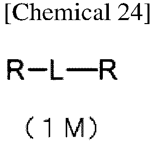

In the formula, L represents the structural unit (1) and R independently represents a reactive functional group.

### (Monomer (2))

The monomer (2-1) is a trifunctional monomer containing one structural unit (2-1) in the molecule and having three reactive functional groups. The monomer (2-2) is a tetrafunctional monomer containing one structural unit (2-2) in the molecule and having four reactive functional groups. The monomer (2), which is one or more monomers selected from a group consisting of the monomer (2-1) and the monomer (2-2), can be used to introduce the structural unit (2) into the charge-transporting polymer. The description of the structural unit (2) can be applied to the structural unit (2) contained in the monomer (2).

The monomer (2-1) is preferably a monomer represented by the following formula (2-1M) for example.

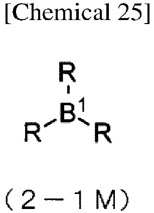

In the formula, B¹ represents the structural unit (2-1), and R independently represents a reactive functional group.

The monomer (2-2) is preferably a monomer represented by the following formula (2-2M) for example.

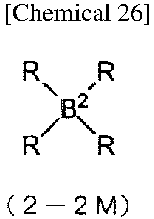

In the formula, B² represents the structural unit (2-2), and R independently represents a reactive functional group.

### (Monomer (3))

The monomer (3) contains one structural unit (3) in the molecule. The monomer (3) can be used to introduce the structural unit (3) into the charge-transporting polymer. The description of the structural unit (3) can be applied to the structural unit (3) contained in the monomer (3). The monomer (3) is a monofunctional monomer having one reactive functional group.

The monomer (1) is preferably a monomer represented by the following formula (3M) for example.

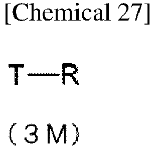

In the formula, T represents the structural unit (3), and R represents the reactive functional group.

### (Monomer (4))

The monomer (4-1) is a monofunctional monomer containing one structural unit (4-1) in the molecule and having one reactive functional group. The monomer (4-2) is a monofunctional monomer containing one structural unit (4-2) in the molecule and having one reactive functional group. The monomer (4), which is one or more monomers selected from a group consisting of the monomer (4-1) and the monomer (4-2), can be used to introduce the structural unit (4) into the charge-transporting polymer. The description of the structural unit (4) can be applied to the structural unit (4) contained in the monomer (4).

The monomer (4-1) is preferably a monomer represented by the following formula (4-1M) for example.

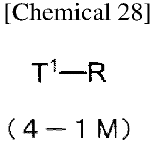

In the formula, T¹ represents the structural unit (4-1), and R represents a reactive functional group.

The monomer (4-2) is preferably a monomer represented by the following formula (4-2M) for example.

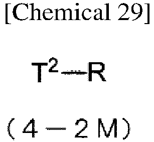

In the formula, T² represents the structural unit (4-2), and R represents a reactive functional group.

### (Reactive functional group)

Reactive functional groups are groups that can react with each other and form bonds between structural units. The bond is preferably a direct bond. The reactive functional group can be appropriately selected according to the desired reaction. For example, when the reaction is a Suzuki coupling reaction described later, the reactive functional group is preferably selected from a group consisting of a boronic acid group, a boronic acid ester group, and a halogen group.

An example of the monomer mixture is a mixture containing: a monomer (1) in which all the reactive functional groups are boronic acid groups or boronic acid ester groups; a monomer (2) in which all the reactive functional groups are halogen groups; a monomer (3) in which the reactive functional group is a halogen group, and a monomer (4) in which the reactive functional group is a halogen group. Another example of the monomer mixture is a mixture containing: a monomer (1) in which all the reactive functional groups are halogen groups; a monomer (2) in which all the reactive functional groups are boronic acid groups or boronic acid ester groups; a monomer (3) in which the reactive functional group is a boronic acid group or a boronic acid ester group; and monomer (4) in which the reactive functional group is a boronic acid group or a boronic acid ester group.

The monomer can be synthesized by a known method. In addition, these monomers can be obtained from, for example, Tokyo Chemical Industry Co., Ltd., Sigma-Aldrich Japan LLC, and the like.

### (Composition of monomer mixture)

The content of each monomer in the monomer mixture can follow the content of the structural unit corresponding to each monomer in the charge-transporting polymer. For example, similar to the content of the structural unit (3) in the charge-transporting polymer, the content of the monomer (3) in the monomer mixture is 30 to 95 mol% based on the monofunctional monomer. For example, similar to the content of the divalent structural unit in the charge-transporting polymer, the content of the bifunctional monomer in the monomer mixture is preferably 10 mol% or more based on all the monomers. That is, the description of the content (numerical range) of the structural units in the charge-transporting polymer can be used as description for the content (numerical range) of the monomer in the monomer mixture by substituting the charge-transporting polymer with the monomer mixture and the structural unit with the monomer.

### [Reaction of monomer mixture]

The reaction is preferably a coupling reaction, and the coupling reaction may be, for example, known reactions such as Suzuki coupling, Negishi coupling, Sonogashira coupling, Stille coupling, Buchwald-Hartwig coupling and the like. Suzuki coupling is, for example, a reaction that causes a cross-coupling reaction using a Pd catalyst between an aromatic boronic acid compound or an aromatic boronic acid ester compound and an aromatic halogen compound. According to Suzuki Coupling, the charge-transporting polymer can be easily prepared by bonding desired aromatic rings to each other.

In Suzuki coupling, for example, Pd compounds such as Pd (0) compounds and Pd (II) compounds, Ni compounds, Ru compounds and the like are used as the catalyst. Examples of the Pd compound include Pd compounds having a phosphine ligand, such as Pd(t-Bu₃P)₂(bis(tri-tert-butylphosphine) palladium (0)), Pd(t-Bu3P)4(tetrakis(tri-tert-butylphosphine) palladium (0)), Pd(PPh3)4(tetrakis(triphenylphosphine) palladium (0)), Pd(dppf)Cl₂([1,1'-bis(diphenylphosphino)ferrocene] palladium (II) dichloride), Pd(dppe)Cl₂([1,2-bis(diphenylphosphino) ethane] palladium (II) dichloride) and the like. In addition, a catalyst species generated by using tris(dibenzylideneacetone) dipalladium (0), palladium (II) acetate and the like as a precursor and mixing the precursor and a phosphine ligand in a reaction system can also be used. Examples of the phosphine ligand in this case include P(t-Bu)₃(tris(t-butyl)phosphine), tributylphosphine, P(c-Hex)₃(tricyclohexylphosphine) and the like.

The reaction solvent may be an organic solvent, and a mixed solvent of water and an organic solvent can be preferably used. Examples of the organic solvent include: an aromatic ether such as 1,2-dimethoxybenzene, 1,3-dimethoxybenzene, anisole, phenetol, 2-methoxytoluene, 3-methoxytoluene, 4-methoxytoluene, 2,3-dimethylanisole, 2,4-dimethylanisole and diphenyl ether; an aromatic hydrocarbon such as benzene, toluene, xylene, mesityrene, tetraline and diphenylmethane; tetrahydrofuran, acetone, acetonitrile, N,N-dimethylformamide and the like. In the reaction, the base includes: carbonates of alkali metals such as Na₂CO₃, K2CO3; hydroxides of alkali metals such as NaOH and KOH; phosphates of alkali metals such as K₃PO₃; water-soluble organic bases such as triethylamine, TMAH (tetramethylammonium hydroxide), TEAH (tetraethylammonium hydroxide); and the like. In addition, it is also possible to add a phase transfer catalyst to promote the reaction. Examples of the phase transfer catalyst include TBAB (tetrabutylammonium bromide), Aliquat 336 (registered trademark, manufactured by SIGMA-ALDRICH, a mixture of trioctylmethylammonium chloride and tricaprylmethylammonium chloride).

### [Dopant]

The organic electronics material can contain any additive, for example, may further contain a dopant. The dopant is not particularly limited as long as it can exhibit a doping effect and improve charge-transporting property by being added to the organic electronics material. P-type doping is preferable for improving hole transportability, and n-type doping is preferable for improving electron transportability. In addition, one type of dopant may be added alone, or a plurality of types of dopants may be mixed and added.

Dopants used for p-type doping are electron-accepting compounds and may be a Lewis acid, a protonic acid, a transition metal compound, an ionic compound, a halogen compound, and a π-conjugated compound. Specifically, the Lewis acids may be FeCl₃, PF₅, AsFs, SbFs, BF₅, BCl₃, BBr3, and the like; the protonic acid may be an inorganic acid such as HF, HCl, HBr, HNO₃, H2SO4, HClO₄ and the like, or an organic acid such as benzensulfonic acid, p-toluene sulfonic acid, dodecylbenzene sulfonic acid, polyvinyl sulfonic acid, methane sulfonic acid, trifluoromethane sulfonic acid, trifluoroacetic acid, 1-butane sulfonic acid, vinyl phenyl sulfonic acid, camphor sulfonic acid; the transition metal compound may be FeOCl, TiCl4, ZrCl4, HfCl₄, NbFs, AlCl₃, NbCl₅, TaCls, MoF₅; the ionic compound may be a salt having perfluoro anion such as tetrakis(pentafluorophenyl)boric acid ion, tris(trifluoromethane sulfonyl)methide ion, bis(trifluoromethane sulfonyl)imide ion, hexafluoroantimonic acid ion, AsF₆⁻(hexafluoroarsenic acid ion), BF₄⁻ (tetrafluoroboric acid ion), PF₆⁻ (hexafluorophosphoric acid ion), a salt having conjugated base of the protonic acid as anion, and the like; the halogen compound may be Cl₂, Br2, I2, ICl, ICl₃, IBr, IF and the like; and the π-conjugated compound may be TCNE (tetracyanoethylene), TCNQ (tetracyanoquinodimethane) and the like.

The dopant used for n-type doping is an electron-donating compound and may be, for example, an alkali metal such as Li, Cs; an alkaline earth metal such as Mg, Ca; a salt of an alkali metal and/or an alkaline earth metal such as LiF, CS2CO3; metal complexes; electron-donating organic compounds and the like.

In order to improve the solvent resistance of the organic layer, a compound that can act as a polymerization initiator for the polymerizable functional group may be used as the dopant.

### [Other optional component]

The organic electronics material may further contain a charge-transporting low molecular weight compound, other polymers and the like.

### [Content]

From the viewpoint of obtaining good charge-transporting property, the content of the charge-transporting polymer in the organic electronics material is preferably 50% by mass or more, more preferably 70% by mass or more, and further preferably 80% by mass or more based on the total mass of the organic electronics material. The upper limit of the content of the charge-transporting polymer is not particularly limited and may be 100% by mass. The content of the charge-transporting polymer may be, for example, 95% by mass or less or 90% by mass or less in consideration of containing an additive such as a dopant.

When a dopant is contained, from the viewpoint of improving the charge-transporting property of the organic electronics material, the content thereof is preferably 0.01% by mass or more, more preferably 0.1% by mass or more, and further preferably 0.5% by mass or more based on the total mass of the organic electronics material. In addition, from the viewpoint of maintaining good film forming property, the content of the dopant is preferably 50% by mass or less, more preferably 30% by mass or less, and further preferably 20% by mass or less based on the total mass of the organic electronics material.

### <Liquid composition>

The liquid composition according to an embodiment of the present invention contains the organic electronics material and a solvent. The liquid composition containing the solvent allows the organic layer to be easily formed by the coating method. The liquid composition can be used as an ink composition.

### [Solvent]

As the solvent, any solvent such as water, an organic solvent, or a mixed solvent thereof can be used. The organic solvent includes: alcohols such as methanol, ethanol and isopropyl alcohol; alkanes such as pentane, hexane and octane; cyclic alkanes such as cyclohexane; aromatic hydrocarbons such as benzene, toluene, xylene, mesitylene, tetraline and diphenylmethane; aliphatic ethers such as ethylene glycol dimethyl ether, ethylene glycol diethyl ether, propylene glycol-1-monomethyl ether acetate; aromatic ethers such as 1,2-dimethoxybenzene, 1,3-dimethoxybenzene, anisole, phenetol, 2-methoxytoluene, 3-methoxytoluene, 4-methoxytoluene, 2,3-dimethylanisole and 2,4-dimethylanisole; aliphatic esters such as ethyl acetate, n-butyl acetate, ethyl lactate and n-butyl lactate; aromatic esters such as phenyl acetate, phenyl propionate, methyl benzoate, ethyl benzoate, propyl benzoate and n-butyl benzoate; aromatic halides such as chlorobenzene, o-dichlorobenzene and 1-chloronaphthalene; amides such as N, N-dimethylformamide and N, N-dimethylacetamide; dimethylsulfoxide, tetrahydrofuran, acetone, chloroform, methylene chloride and the like. The liquid composition may contain one type of solvent alone, or may contain two or more types of solvents.

From the viewpoint of obtaining excellent solubility of the charge-transporting polymer, the liquid composition preferably contains a solvent comprising at least one selected from a group consisting of an aromatic ether and an aromatic halide. When the liquid composition contains a solvent containing an aromatic ether and/or an aromatic halide, the charge-transporting polymer can be easily dissolved in a solvent without introducing many linear alkylene groups or linear alkyl groups that may be introduced into the charge-transporting polymer to improve solubility. A low content of the linear alkylene group and the linear alkyl group in the charge-transporting polymer is preferable for improving the life characteristics of the organic electronics element. When the structural unit (1) is introduced into the charge-transporting polymer, the solubility of the charge-transporting polymer in common solvents such as aromatic hydrocarbons tends to decrease. However, when the liquid composition contains a solvent comprising an aromatic ether and/or an aromatic halide, good solubility can be easily obtained even when the charge-transporting polymer comprises the structural unit (1).

In a preferred example, the liquid composition preferably contains a solvent comprising an aromatic ether. The aromatic ether is preferably an aromatic ether represented by the following formula (A). Specifically, the aromatic ether is preferably anisole and/or phenetol, and more preferably anisole. When a solvent comprising an aromatic ether is used, the charge-transporting polymer can be efficiently and easily dissolved. When the solvent comprising an aromatic ether is a mixed solvent, the content of the aromatic ether in the mixed solvent is preferably 50% by mass or more, more preferably 70% by mass or more, and further preferably 90% by mass or more based on the total amount of the solvent. The solvent may be a solvent consisting of an aromatic ether only.

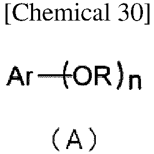

In the formula, Ar represents an aromatic hydrocarbon group, R represents a hydrocarbon group, and n represents an integer greater than or equal to 1.

As for the aromatic hydrocarbon group, the description regarding the aromatic hydrocarbon group in the structural unit (1) described above can be applied. Ar is preferably a benzene group or a naphthalene group, and more preferably a benzene group. The hydrocarbon group is preferably an aliphatic hydrocarbon group, and more preferably an alkyl group. The hydrocarbon group preferably has 1 to 8 carbon atoms, more preferably 1 to 6 carbon atoms, and further preferably 1 to 4 carbon atoms. Specifically, the hydrocarbon group may be an alkyl group, an ethyl group, a propyl group and the like. When Ar is a benzene group, n is preferably 1 to 3, more preferably 1 or 2, and further preferably 1.

In another preferred example, the liquid composition preferably contains a solvent comprising an aromatic halide. The aromatic ether is preferably an aromatic ether represented by the following formula (B). Specifically, the aromatic halide is preferably chlorobenzene and/or dichlorobenzene, and more preferably chlorobenzene. When a solvent comprising an aromatic halide is used, the charge-transporting polymer can be efficiently and easily dissolved. When the solvent comprising an aromatic halide is a mixed solvent, the content of the aromatic halide in the mixed solvent is preferably 50% by mass or more, preferably 70% by mass or more, and further preferably 90% by mass or more based on the total amount of the solvent. The solvent may be a solvent consisting of an aromatic halide only.

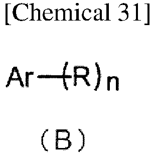

In the formula, Ar represents an aromatic hydrocarbon group, R represents a halogen atom, and n represents an integer greater than or equal to 1.

As for the aromatic hydrocarbon group, the description regarding the aromatic hydrocarbon group in the structural unit (1) described above can be applied. Ar is preferably a benzene group or a naphthalene group, and more preferably a benzene group. The halogen atom is preferably a chlorine atom. When Ar is a benzene group, n is preferably 1 to 3, more preferably 1 or 2, and further preferably 1.

### [Polymerization initiator]

The liquid composition preferably contains a polymerization initiator in order to make the oxetane group contained in the charge-transporting polymer react. As the polymerization initiator, known radical polymerization initiators, cationic polymerization initiators, anionic polymerization initiators and the like can be used. From the viewpoint that the liquid composition can be easily prepared, it is preferable to use a substance having both a function as a dopant and a function as a polymerization initiator. Such a substance may be the ionic compound described above.

### [Additive]

The liquid composition may further contain an additive as an optional component. The additive may be, for example, a polymerization inhibitor, a stabilizer, a thickener, a gelling agent, a flame retardant, an oxidation inhibitor, a reduction inhibitor, an oxidizing agent, a reducing agent, a surface modifier, an emulsifier, a defoamer, a dispersant, a surfactant and the like.

### [Content]

The content of the solvent in the liquid composition can be determined in consideration of application to various coating methods. For example, the content of the solvent is preferably such that the ratio of the charge-transporting polymer to the solvent is 0.1% by mass or more, more preferably 0.2% by mass or more, and further preferably 0.5% by mass or more. In addition, the content of the solvent is preferably such that the ratio of the charge-transporting polymer to the solvent is 20% by mass or less, more preferably 15% by mass or less, and further preferably 10% by mass or less.

### <Organic layer>

The organic layer according to an embodiment of the present invention is a layer formed using the organic electronics material or the liquid composition. The organic layer exhibits good charge-transporting property. By using the liquid composition, the organic layer can be satisfactorily and easily formed by a coating method. The coating method may be known methods including, for example, a spin coating method; a casting method; a dipping method; a plate printing method such as letterpress printing, intaglio printing, offset printing, flat plate printing, letterpress reversal offset printing, screen printing and gravure printing; a plateless printing method such as an inkjet method, and the like. When the organic layer is formed by the coating method, the layer of the liquid composition obtained after coating may be dried using a hot plate or an oven to remove the solvent.

Because the charge-transporting polymer contains the structural unit (3) having a polymerizable functional group, the polymerization reaction of the charge-transporting polymer can be made to proceed by light irradiation, heat treatment or the like to obtain a cured organic layer. By laminating the cured organic layers, it is possible to easily increase the number of layers of the organic electronics element.

From the viewpoint of improving the efficiency of charge transport, the thickness of the organic layer after drying or curing is preferably 0.1 nm or more, more preferably 1 nm or more, and further preferably 3 nm or more. In addition, from the viewpoint of reducing the electric resistance, the thickness of the organic layer is preferably 300 nm or less, more preferably 200 nm or less, and further preferably 100 nm or less.

### <Organic electronics element>

The organic electronics element according to an embodiment of the present invention has at least one organic layer described above. The organic electronics element may be an organic EL element such as an organic light emitting diode (OLED), an organic photoelectric conversion element, and an organic transistor. The organic electronics element preferably has a structure in which the organic layer is arranged between at least a pair of electrodes.

### <Organic electroluminescence element (organic EL element)>

The organic EL element according to an embodiment of the present invention has at least one organic layer described above. The organic EL element usually includes a light emitting layer, an anode, a cathode, and a substrate, and includes, if necessary, other functional layers such as a hole transporting layer like a hole injection layer and a hole transport layer, an electron transporting layer like an electron transport layer, and the like. Each layer may be formed by a vapour deposition method or a coating method. The organic EL element preferably has the organic layer as a light emitting layer or another functional layer, more preferably as another functional layer, and further preferably as at least one of a hole injection layer and a hole transport layer.

FIG. 1 is a schematic cross-sectional view showing an embodiment of the organic EL element. The organic EL element of FIG. 1 is a multi-layered element, and has a substrate 8, an anode 2, a hole injection layer 3 and a hole transport layer 6, a light emitting layer 1, an electron transport layer 7, an electron injection layer 5, and a cathode 4 in this order.

### [Light emitting layer]

As the material used for the light emitting layer, a light emitting material such as a low molecular weight compound, a polymer, or a dendrimer can be used. The polymer is preferable because of the high solubility in solvents and suitability for coating methods. The light emitting material includes fluorescent materials, phosphorescent materials, thermal activated delayed fluorescent materials (TADF) and the like.

### [Hole transporting layer]

The organic EL element preferably includes the organic layer as a hole transporting layer, and more preferably as at least one of a hole injection layer and a hole transport layer. As described above, these layers can be easily formed by using a liquid composition containing the organic electronics material.

When the organic EL element has the organic layer as a hole injection layer and further has a hole transport layer, a known material can be used for the hole transport layer. In addition, when the organic EL element has the organic layer as a hole transport layer and further has a hole injection layer, a known material can be used for the hole injection layer. The hole injection layer and the hole transport layer may be the organic layer.

When the hole transport layer is a cured organic layer, a light emitting layer can be easily formed on the upper layer by using an ink composition. In this case, the polymerization initiator may be contained in the organic layer which is a hole transport layer, or may be contained in the organic layer which is the lower layer of the hole transport layer.

### [Electron transporting layer]

The material used for the electron transporting layer such as an electron transport layer and an electron injection layer may be phenanthroline derivatives, bipyridine derivatives, nitro-substituted fluorene derivatives, diphenylquinone derivatives, thiopyrandioxide derivatives, condensed ring tetracarboxylic acid anhydrides of naphthalene, perylene and the like, carbodiimide, fluorenylidene methane derivatives, anthraquinodimethane and anthron derivatives, oxadiazole derivatives, thiadiazol derivatives, benzoimidazole derivatives, quinoxalin derivatives, aluminum complex and the like. In addition, the organic electronics material can also be used.

### [Cathode]

As the cathode material, for example, a metal or a metal alloy such as Li, Ca, Mg, Al, In, Cs, Ba, Mg/Ag, LiF, CsF is used.

### [Anode]

As the anode material, for example, a metal (for example, Au) or other conductive materials are used. Other materials may be, for example, oxides (eg. ITO: indium oxide/tin oxide), conductive polymers (eg. polythiophene-polystyrene sulfonic acid mixture (PEDOT:PSS)).

### [Substrate]

Glass, plastic and the like can be used as the substrate. The substrate is preferably transparent and preferably has flexibility. Quartz glass, resin film and the like are preferably used.

The resin film is preferably a light-transmitting resin film. When a resin film is used, the resin film may be coated with an inorganic substance such as silicon oxide or silicon nitride in order to suppress the permeation of water vapour, oxygen and the like.

### [Sealing]

The organic EL element may be sealed in order to reduce the influence of the outside air and prolong the life. As the material used for sealing, glass, a plastic film, or an inorganic substance such as silicon oxide or silicon nitride can be used, but the material is not limited thereto.

### [Emission color]

The emission color of the organic EL element is not particularly limited. The white organic EL element is preferable because it can be used for various lighting fixtures such as household lighting, vehicle interior lighting, backlights of clocks or liquid crystal, and the like.

### <Display element, lighting device, display device>

The display element according to an embodiment of the present invention includes the organic EL element. For example, by using the organic EL elements as elements corresponding to each pixel of red, green, and blue (RGB), color display elements can be obtained.

In addition, the lighting device according to an embodiment of the present invention includes the organic EL element. Further, the display device according to an embodiment of the present invention includes the lighting device and a liquid crystal element as a display part. For example, the display device may be a display device using the lighting device as a backlight and a known liquid crystal element as a display part, that is, may be a liquid crystal display device.

### <Example of Embodiment>

Examples of preferred embodiments of the present invention are given below. Embodiments of the present invention are not limited to the following examples.
[1] An organic electronics material containing a charge-transporting polymer, wherein the charge-transporting polymer comprises
   a structural unit represented by the above formula (1),
   at least one structural unit selected from a group consisting of a structural unit represented by the above formula (2-1) and a structural unit represented by the above formula (2-2),
   a structural unit represented by the above formula (3), and
   at least one structural unit selected from a group consisting of a structural unit represented by the above formula (4-1) and a structural unit represented by the above formula (4-2).
[2] The organic electronics material according to the above [1], wherein the structural unit represented by the above formula (1) comprises at least one structural unit selected from a group consisting of a structural unit represented by the above formula (1b), a structural unit represented by the above formula (1c), a structure represented by the above formula (1d), and a structural unit represented by the above formula (1e).
[3] The organic electronics material according to the above [1] or [2], wherein the at least one structural unit selected from a group consisting of a structural unit represented by the above formula (2-1) and a structural unit represented by the above formula (2-2) comprises a structural unit represented by the above formula (2-1c), a structural unit represented by the above formula (2-1d), and a structural unit represented by the above formula (2-2b).
[4] The organic electronics material according to any one of [1] to [3], wherein the structural unit represented by the above formula (3) comprises a structural unit represented by the above formula (3a).
[5] The organic electronics material according to any one of the above [1] to [4], wherein the at least one structural unit selected from a group consisting of a structural unit represented by the above formula (4-1) and a structural unit represented by the above formula (4-2) comprises at least one structural unit selected from a group consisting of a structural unit represented by the above formula (4-1b) and a structural unit represented by the above formula (4-2b).
[6] A method for preparing a charge-transporting polymer, which prepares a charge-transporting polymer used in the organic electronics material, wherein
   the method includes making a monomer mixture react in a solvent containing an aromatic ether, the monomer mixture containing a bifunctional monomer having a structural unit represented by the above formula (1), at least one trifunctional or tetrafunctional monomer selected from a group consisting of a trifunctional monomer having a structural unit represented by the above formula (2-1) and a tetrafunctional monomer having a structural unit represented by the above formula (2-2), a monofunctional monomer having a structural unit represented by the above formula (3), and at least one monofunctional monomer selected from a group consisting of a monofunctional monomer having a structural unit represented by the above formula (4-1) and a monofunctional monomer having a structural unit represented by the above formula (4-2).
[7] A liquid composition containing the organic electronics material according to any one of the above [1] to [5] and a solvent.
[8] The liquid composition according to the above [7], wherein the solvent comprises an aromatic ether.
[9] An organic layer formed using the organic electronics material according to any one of the above [1] to [5] or the liquid composition according to [7] or [8].
[10] An organic electronics element including the organic layer according to the above [9].
[11] An organic electroluminescence element including the organic layer according to the above [9].
[12] An organic electroluminescence element including the organic layer according to the above [9] as a hole injection layer or a hole transport layer.
[13] A display element including the organic electroluminescence element according to the above [11] or [12].
[14] A lighting device including the organic electroluminescence element according to the above [11] or [12].
[15] A display device including the lighting device according to the above [14] and a liquid crystal element as a display part.

### Examples

Embodiments of the present invention are specifically described with reference to examples. Embodiments of the present invention are not limited to the following examples.

### <Preparation of charge-transporting polymer>

### [Preparation of Pd catalyst]

Tris(dibenzylideneacetone) dipalladium (73.2 mg, 80 µmol) was weighed in a sample tube at room temperature in a glove box under a nitrogen atmosphere, toluene (15 mL) was added, and the mixture was stirred for 30 minutes. Similarly, tris(t-butyl) phosphine (129.6 mg, 640 µmol) was weighed into a sample tube, toluene (5 mL) was added, and the mixture was stirred for 5 minutes. These solutions are mixed and stirred at room temperature for 30 minutes, and the catalyst solution (hereinafter referred to as "Pd catalytic solution") was obtained. In the preparation of the Pd catalyst, all solvents were used after being degassed with nitrogen bubbles for at least 30 minutes.

### [Preparation of charge-transporting polymer]

Charge-transporting polymers 1 to 15 were prepared according to the following. The monomers used are shown in Table 1.

### [Table 1-1]

**Table 1**

| Bifunctional monomer | Trifunctional or tereafunctional monomer | Monofunctional monomer (3) | Monofunctional monomer (4) | Monofunctional monomer |
|---|---|---|---|---|
| 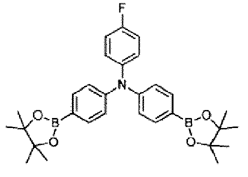 Monomer (1b) | 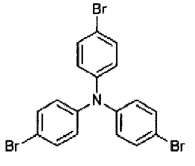 Monomer (2-1c) | 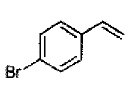 Monomer (3a) | 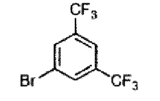 Monomer (4-1b) | 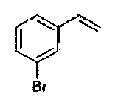 Monomer (3x1) |
| 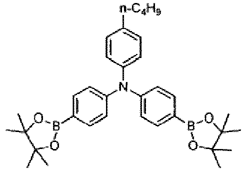 Monomer (1x) | 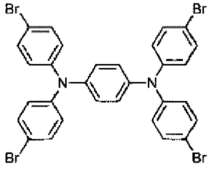 Monomer (2-2b) | 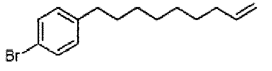 Monomer (3b) | 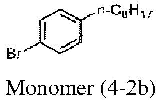 Monomer (4-2b) | 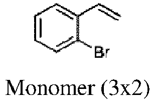 Monomer (3x2) |

**[Table 1-2]**

| Connected to Table 1 | | | | |
|---|---|---|---|---|
| Bifunctional monomer | Trifunctional or tereafunctional monomer | Monofunctional monomer (3) | Monofunctional monomer (4) | Monofunctional monomer |
| | | | | 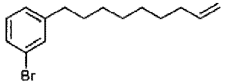 Monomer (3yl) |
| | | | | 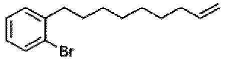 Monomer (3y2) |
| | | | | 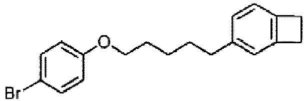 Monomer (3z) |

### (Charge-transporting polymer 1)

In a three-necked round bottom flask, monomer (1b) (5.0 mmol), monomer (2-1c) (2.0 mmol), monomer (3a) (2.0 mmol), monomer (4-1b) (2.0 mmol), methyltri-n-octyl ammonium chloride ("Alicoat 336" of Alfa Aesar) (0.04 g), an aqueous potassium hydroxide solution of 3M (7.79 g), and toluene (50 mL) were added, and the Pd catalytic solution (1.0 mL) was further added and mixed. The obtained mixture was heated to reflux for 2 hours. All operations till now were performed under a nitrogen stream. In addition, all the solvents were used after being degassed by nitrogen bubbling for 30 minutes or more.

After completion of the reaction, the organic layer was washed with water and poured into methanol-water (9:1). The resulting precipitate was collected by suction filtration and washed with methanol-water (9:1). The obtained precipitate was dissolved in toluene and reprecipitated from methanol. The obtained precipitate was collected by suction filtration and dissolved in toluene, a metal adsorbent ("Triphenylphosphine, polymer-bound on styrene-divinylbenzene copolymer" manufactured by Strem Chemicals, 200 mg per 100 mg of precipitate) was added, and the mixture was stirred at 80°C for 2 hours. After completion of the stirring, the metal adsorbent and the insoluble matter were removed by filtration, and then reprecipitation from methanol was performed. The resulting precipitate was collected by suction filtration and washed with methanol. The obtained precipitate was vacuum dried to obtain charge-transporting polymer 1. The charge-transporting polymer 1 had a number average molecular weight of 14,100 and a weight average molecular weight of 52,600.

The number average molecular weight and the weight average molecular weight were measured by GPC (polystyrene conversion) using tetrahydrofuran (THF) as the eluent. The measurement conditions are as follows.
Equipment: High performance liquid chromatograph Prominence of Shimadzu Corporation
   liquid transfer pump (LC-20AD)
   degassing unit (DGU-20A)
   autosampler (SIL-20AHT)
   column oven (CTO-20A)
   PDA detector (SPD-M20A)
   differential refractometer (RID-20A)
Column: Gelpack (registered trademark)
   GL-A160S (serial number: 686-1J27)
   GL-A150S (serial number: 685-1J27) of Hitachi Kasei Co., Ltd.
Eluent: tetrahydrofuran (THF) (for HPLC, containing stabilizer) of Fujifilm Wako Pure Chemical Industries, Ltd.
Flow velocity: 1 mL / min
Column temperature: 40°C
Detection wavelength: 254 nm
Molecular weight standard substance: PStQuick A/B/C of Tosoh Corporation

### (Charge-transporting polymer 2 to 15)

Charge-transporting polymers 2 to 15 were prepared in the same manner as charge-transporting polymer 1 except that the monomers used were changed to the monomers shown in Table 2.

Table 2 shows the monomer ratios of the charge-transporting polymers 1 to 15, the content of the monomer (3), the number average molecular weight, and the weight average molecular weight.

### [Table 2]

**Table 2**

| Charge-tra | Monomer | | | | | (3)/ | Mn | Mw | |
|---|---|---|---|---|---|---|---|---|---|
| nsporting polymer | Bifunctional | Trifunctional/ tetrafunctional | Monofunct ional (3) | Monofunct ional (4) | Monofunct ional | (monofunction al polymer) | | | |
| 1 | (lb) | (2-1c) | (3a) | (4-1b) | | 50 | 14,100 | 52,600 | Example |
| | 50 | 20 | 20 | 20 | | | | | |
| 2 | (lb) | (2-1c) | (3a) | (4-1b) | | 75 | 11,650 | 89,700 | Example |
| | 50 | 20 | 30 | 10 | | | | | |
| 3 | (lb) | (2-2b) | (3a) | (4-1b) | | 50 | 13,200 | 50,000 | Example |
| | 40 | 10 | 20 | 20 | | | | | |
| 4 | (lb) | (2-1c) | (3a) | (4-2b) | | 50 | 11,700 | 77,300 | Example |
| | 50 | 20 | 20 | 20 | | | | | |
| 5 | (lb) | (2-2b) | (3a) | (4-2b) | | 50 | 10,200 | 44,600 | Example |
| | 40 | 10 | 20 | 20 | | | | | |
| 6 | (lb) | (2-1c) | (3b) | (4-1b) | | 50 | 12,800 | 48,400 | Example |
| | 50 | 20 | 20 | 20 | | | | | |
| 7 | (lb) | (2-1c) | (3b) | (4-1b) | | 75 | 13,000 | 49,900 | Example |
| | 50 | 20 | 30 | 10 | | | | | |
| 8 | (lb) | (2-2b) | (3b) | (4-2b) | | 50 | 12,000 | 45,800 | Example |
| | 40 | 10 | 20 | 20 | | | | | |
| 9 | (lb) | (2-1c) | | (4-1b) | (3x1) | 0 | 14,300 | 48,300 | Comparative example |
| | 50 | 20 | | 20 | 20 | | | | |
| 10 | (lb) | (2-1c) | | (4-2b) | (3x1) | 0 | 13,800 | 52,000 | Comparative example |
| | 50 | 20 | | 20 | 20 | | | | |
| 11 | (lb) | (2-1c) | | (4-2b) | (3x2) | 0 | 13,400 | 51,200 | Comparative example |
| | 50 | 20 | | 20 | 20 | | | | |
| 12 | (lb) | (2-1c) | | (4-2b) | (3yl) | 0 | 11,900 | 50,900 | Comparative example |
| | 50 | 20 | | 20 | 20 | | | | |
| 13 | (lb) | (2-1c) | | (4-2b) | (3v2) | 0 | 12,900 | 48,000 | Comparative example |
| | 50 | 20 | | 20 | 20 | | | | |
| 14 | (lb) | (2-1c) | (3a) | | (3z) | 50 | 14,000 | 48,700 | Comparative example |
| | 50 | 20 | 20 | | 20 | | | | |
| 15 | (lx) | (2-1c) | (3a) | (4-2b) | | 50 | 12,700 | 48,400 | Comparative example |
| | 50 | 20 | 20 | 20 | | | | | |

In Table 2, the values listed below each monomer number are the monomer ratios used in the synthesis. Further, in the column of "(3)/(monofunctional monomer)", the content (mol%) of the monomer (3) based on the total amount of the monofunctional monomer was listed.

### <Evaluation>

### [Storage stability evaluation]

Ink compositions 1 to 15 were manufactured using the charge-transporting polymers 1 to 15 according to the following, and the storage stability was evaluated. The results are shown in Table 3.

The following polymerization initiator (10 mg) was weighed into a 20 mL screw tube, chlorobenzene (10 mL) was added, and the mixture was stirred to obtain a polymerization initiator solution. The charge-transporting polymer (10 mg) and chlorobenzene (792 µL) were then added to a 9 mL screw tube to dissolve the charge-transporting polymer. Then, 101 µL of the polymerization initiator solution was added into the 9 mL screw tube and stirred to prepare an ink composition. The obtained ink composition was kept still in the air at room temperature (25°C) and humidity of 40% for 24 hours, and then the color change of the ink composition was visually confirmed.

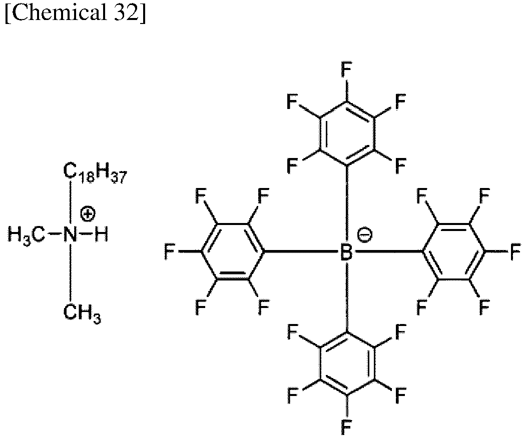

### [Table 3]

**Table 3**

| Charge-transporting polymer | Storage stability | | |
|---|---|---|---|
| | Liquid composition | discoloration | |
| 1 | 1 | No | Example |
| 2 | 2 | No | Example |
| 3 | 3 | No | Example |
| 4 | 4 | No | Example |
| 5 | 5 | No | Example |
| 6 | 6 | No | Example |
| 7 | 7 | No | Example |
| 8 | 8 | No | Example |
| 9 | 9 | Yes | Comparative example |
| 10 | 10 | Yes | Comparative example |
| 11 | 11 | Yes | Comparative example |
| 12 | 12 | Yes | Comparative example |
| 13 | 13 | Yes | Comparative example |
| 14 | 14 | Yes | Comparative example |
| 15 | 15 | Yes | Comparative example |

As shown in Table 3, the liquid composition according to the embodiment of the present invention had excellent storage stability. According to the liquid composition according to the embodiment of the present invention, the organic layer can be formed efficiently and stably. In addition, because the charge-transporting polymer has a structural unit (3) containing a polymerizable functional group that contributes to the curing reaction, it is possible to form a cured organic layer.

### [Reference Signs List]

- 1: light emitting layer
- 2: anode
- 3: hole injection layer
- 4: cathode
- 5: electron injection layer
- 6: hole transport layer
- 7: electron transport layer
- 8: board

## Claims

1. An organic electronics material containing a charge-transporting polymer, wherein the charge-transporting polymer comprises
a structural unit represented by a formula (1) below,
at least one structural unit selected from a group consisting of a structural unit represented by a formula (2-1) below and a structural unit represented by a formula (2-2) below,
a structural unit represented by a formula (3) below, and
at least one structural unit selected from a group consisting of a structural unit represented by a formula (4-1) below and a structural unit represented by a formula (4-2) below, 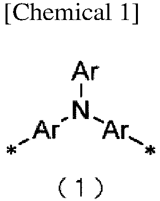 (in the formula, Ar independently represents a substituted or unsubstituted aromatic hydrocarbon group, and at least one Ar is an aromatic hydrocarbon group having a substituent comprising at least one selected from a group consisting of a fluoro group and a fluoroalkyl group) 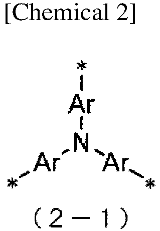 (in the formula, Ar independently represents a substituted or unsubstituted aromatic hydrocarbon group) 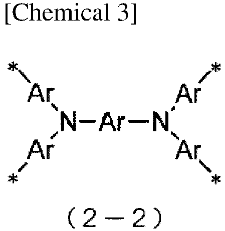 (in the formula, Ar independently represents a substituted or unsubstituted aromatic hydrocarbon group) 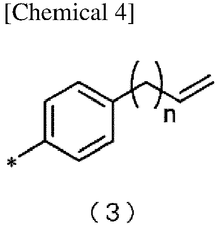 (in the formula, n represents an integer of 0 to 20) 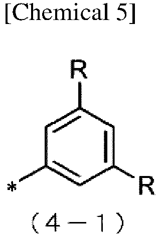 (in the formula, R independently represents a fluoro group and a fluoroalkyl group) 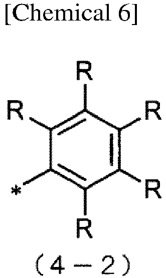 (in the formula, R independently represents a hydrogen atom or a linear alkyl group, and at least one R is a linear alkyl group).

2. The organic electronics material according to claim 1, wherein the structural unit represented by the formula (1) comprises at least one structural unit selected from a group consisting of a structural unit represented by a formula (1b) below, a structural unit represented by a formula (1c) below, a structure represented by a formula (1d) below, and a structural unit represented by a formula (1e) below,

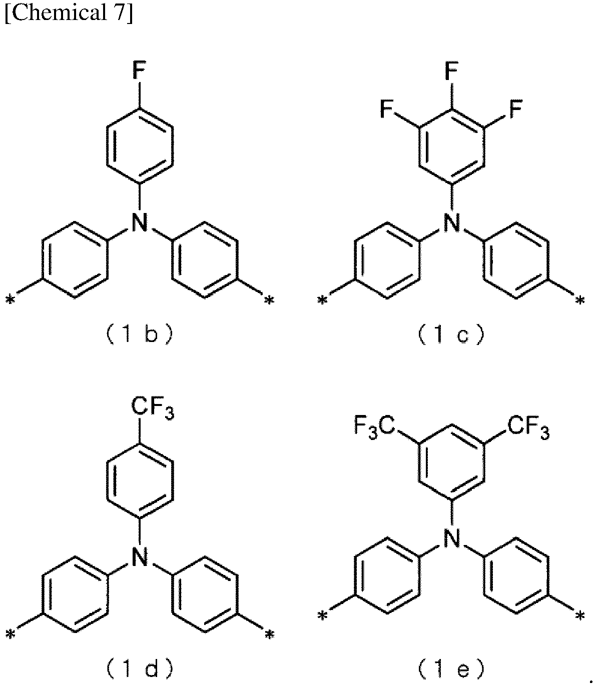

3. The organic electronics material according to claim 1 or 2, wherein the at least one structural unit selected from the group consisting of the structural unit represented by the formula (2-1) and the structural unit represented by the formula (2-2) comprises a structural unit represented by a formula (2-1c) below, a structural unit represented by a formula (2-1d) below, and a structural unit represented by a formula (2-2b) below,

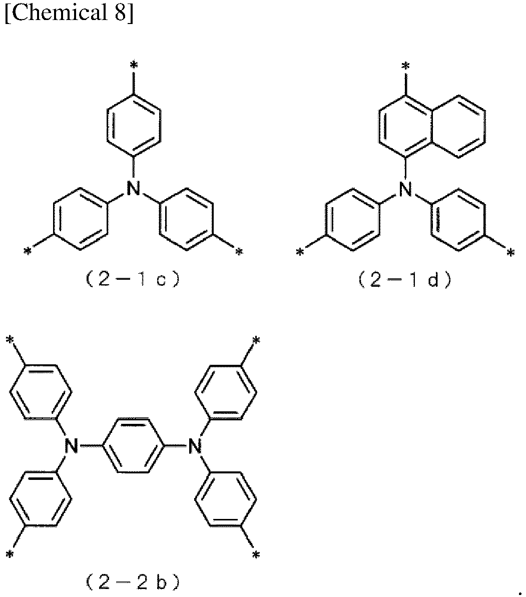

4. The organic electronics material according to any one of claims 1 to 3, wherein the structural unit represented by the formula (3) comprises a structural unit represented by a formula (3a) below,

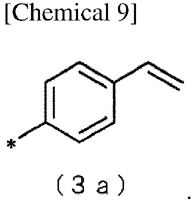

5. The organic electronics material according to any one of claims 1 to 4, wherein the at least one structural unit selected from the group consisting of the structural unit represented by the formula (4-1) and the structural unit represented by the formula (4-2) comprises at least one structural unit selected from a group consisting of a structural unit represented by a formula (4-1b) below and a structural unit represented by a formula (4-2b) below,

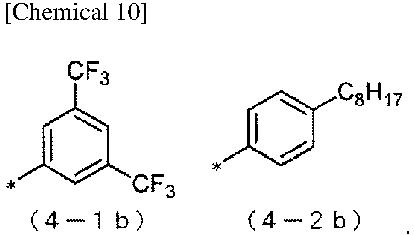

6. A method for preparing a charge-transporting polymer, which prepares a charge-transporting polymer used in the organic electronics material according to any one of claims 1 to 5, wherein
the method includes making a monomer mixture react, the monomer mixture containing a bifunctional monomer having the structural unit represented by the formula (1), at least one trifunctional or tetrafunctional monomer selected from a group consisting of a trifunctional monomer having the structural unit represented by the formula (2-1) and a tetrafunctional monomer having the structural unit represented by the formula (2-2), a monofunctional monomer having the structural unit represented by the formula (3), and at least one monofunctional monomer selected from a group consisting of a monofunctional monomer having the structural unit represented by the formula (4-1) and a monofunctional monomer having the structural unit represented by the formula (4-2).

7. A liquid composition containing the organic electronics material according to any one of claims 1 to 5 and a solvent.

8. The liquid composition according to claim 7, wherein the solvent comprises an aromatic ether.

9. An organic layer formed using the organic electronics material according to any one of claims 1 to 5 or the liquid composition according to claim 7 or 8.

10. An organic electronics element including the organic layer according to claim 9.

11. An organic electroluminescence element including the organic layer according to claim 9.

12. An organic electroluminescence element including the organic layer according to claim 9 as a hole injection layer or a hole transport layer.

13. A display element including the organic electroluminescence element according to claim 11 or 12.

14. A lighting device including the organic electroluminescence element according to claim 11 or 12.

15. A display device including the lighting device according to claim 14 and a liquid crystal element as a display part.
